(19) Europäisches Patentamt
European Patent Office
Office européen des brevets

(11) **EP 2 860 539 B1**

(12) **EUROPEAN PATENT SPECIFICATION**

(45) Date of publication and mention
of the grant of the patent:
**28.11.2018 Bulletin 2018/48**

(51) Int Cl.:
**G01R 31/36** (2006.01)     **H01M 10/48** (2006.01)
**H02J 7/00** (2006.01)

(21) Application number: **13801338.8**

(22) Date of filing: **27.05.2013**

(86) International application number:
**PCT/JP2013/064625**

(87) International publication number:
**WO 2013/183480 (12.12.2013 Gazette 2013/50)**

(54) **STATE-OF-CHARGE ESTIMATION METHOD AND STATE-OF-CHARGE ESTIMATION DEVICE**

VERFAHREN ZUR SCHÄTZUNG DES LADEZUSTANDS UND VORRICHTUNG ZUR SCHÄTZUNG DES LADUNGSZUSTANDES

PROCÉDÉ D'ESTIMATION D'UN ÉTAT DE CHARGE ET DISPOSITIF D'ESTIMATION D'UN ÉTAT DE CHARGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.06.2012 JP 2012127634**

(43) Date of publication of application:
**15.04.2015 Bulletin 2015/16**

(73) Proprietor: **Kabushiki Kaisha Toyota Jidoshokki
Kariya-shi, Aichi 448-8671 (JP)**

(72) Inventors:
• **ADANIYA, Hiroko
Kariya-shi, Aichi 448-8671 (JP)**
• **KOBAYASHI, Mitsugu
Kariya-shi, Aichi 448-8671 (JP)**
• **TSUZUKU, Takahiro
Kariya-shi, Aichi 448-8671 (JP)**

(74) Representative: **TBK
Bavariaring 4-6
80336 München (DE)**

(56) References cited:
**WO-A1-2009/149273    WO-A1-2011/122164
DE-A1- 10 305 638      JP-A- 2002 303 658
JP-A- 2008 096 328     JP-A- 2008 256 436
JP-A- 2011 209 237**

EP 2 860 539 B1

**Description**

TECHNICAL FIELD

The present invention relates to a state-of-charge estimation method and state-of-charge estimation device for estimating the state of charge of a secondary battery.

BACKGROUND ART

Examples of such state-of-charge estimation methods conventionally used include, for instance, the state-of-charge estimation method disclosed in Patent Literature 1 below. In conventional methods, the state of charge of a secondary battery is estimated through approximation, by a voltage characteristic expression, of the time change of an open-circuit voltage of the secondary battery, after termination of charge and discharge, and by calculating the open-circuit voltage from the voltage characteristic expression where the secondary battery is stable. Specifically, the open-circuit voltage of the secondary battery is measured a plurality of times over a predefined data acquisition period after termination of charge and discharge. The open-circuit voltage at stability is calculated by applying the measured open-circuit voltages to the voltage characteristic expression to work out parameters comprised in the voltage characteristic expression.

Patent Literature 1: Japanese Patent Application Publication No. 2008-96328

Prior art which is related to this field of technology can be found e.g. in document WO 2009/149273 A1 disclosing a method and system for determining state of charge of an energy delivery device, in document JP 2008 096328 A disclosing a charging rate estimation method, charging rate estimating device, and secondary battery power supply system, and in document DE 103 05 638 A1 disclosing a method and device for estimating an open-circuit voltage of a battery.

DISCLOSURE OF THE INVENTION

The inventors studied the charge and discharge characteristics of various secondary batteries, and found out that a voltage-change convergence time $\tau$ from termination of charge and discharge of a secondary battery until convergence of a change in open-circuit voltage takes on a constant value for each combination of a state of charge of the secondary battery at the time of termination of charge and discharge, as estimated on the basis of an integrated current value or an estimated open-circuit voltage that is worked out using a closed-circuit voltage, and the temperature of the secondary battery at the time of termination of charge and discharge. In a conventional method, the measured open-circuit voltage is used only in a voltage characteristic expression, but a feature where the voltage-change convergence time $\tau$ takes on a constant value for each combination of temperature and state of charge of a secondary battery at the time of termination of charge and discharge is not exploited. Accordingly a greater number of measured values of open-circuit voltage are necessary, and the time required for estimating the state of charge is longer. Herein, the estimated open-circuit voltage that is worked out using the closed-circuit voltage denotes an open-circuit voltage estimated on the basis of closed-circuit voltage and current.

With a view to solving the above problem, it is an object of the present invention to provide a state-of-charge estimation method and a state-of-charge estimation device that allow estimating the state of charge using a smaller number of measured values of open-circuit voltage, and allows shortening the time required for estimating the state of charge.

The state-of-charge estimation method and the state-of-charge estimation device of the present invention are defined by the respective claims.

The state-of-charge estimation method and state-of-charge estimation device of the present invention involve measuring beforehand a voltage-change convergence time $\tau$ from termination of charge and discharge of the secondary battery until convergence of change in the open-circuit voltage, for each combination of state of charge of the secondary battery at the time of termination of charge and discharge and the temperature of the secondary battery at the time of termination of charge and discharge, and upon termination of the charge and discharge of the secondary battery, selecting the voltage-change convergence time $\tau$ corresponding to the state of charge and the temperature at the time of termination of charge and discharge, and using the selected voltage-change convergence time $\tau$ in a voltage characteristic expression. Therefore, it becomes possible to estimate the state of charge using a smaller number of measured values of open-circuit voltage, and to shorten the time required for estimation of the state of charge.

BRIEF DESCRIPTION OF THE DRAWINGS

Fig. 1 is an explanatory diagram illustrating the change in open-circuit voltage of a secondary battery after charging termination;

Fig. 2 is an explanatory diagram illustrating the change in open-circuit voltage of a secondary battery after discharge termination;

Fig. 3 is an explanatory diagram illustrating a map that includes a plurality of voltage-change convergence times $\tau$ measured beforehand based on a state-of-charge estimation method of the present embodiment;

Fig. 4 is a flowchart illustrating a state-of-charge estimation method after creation of the map of Fig. 3; and

Fig. 5 is a block diagram illustrating a state-of-charge estimation device for carrying out the state-of-charge estimation method of the present embodiment.

BEST MODE FOR CARRYING OUT THE INVENTION

Modes for carrying out the present invention will be explained next with reference to accompanying drawings.

Embodiment 1

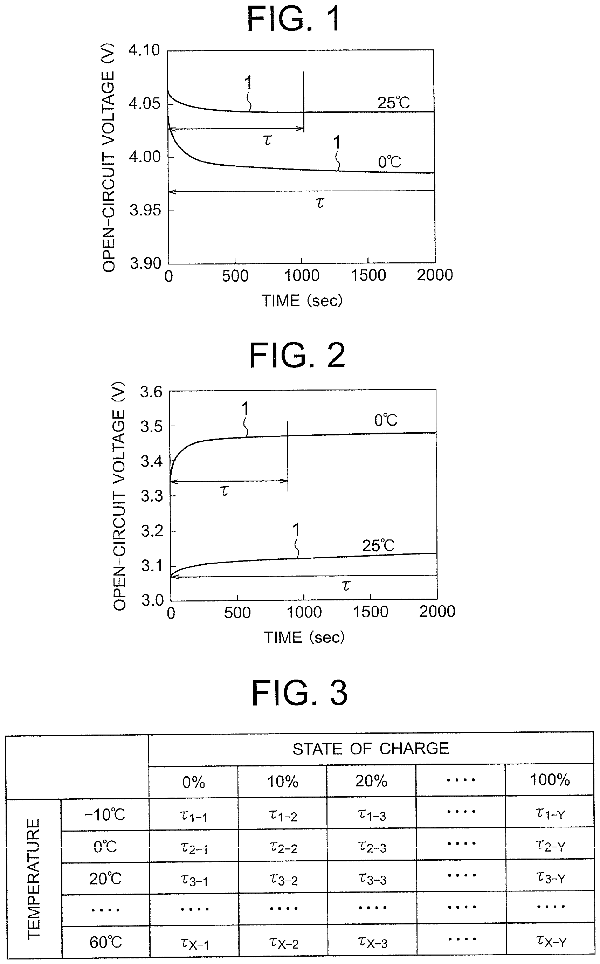

Fig. 1 is an explanatory diagram illustrating the change in open-circuit voltage of a secondary battery after charging termination, and Fig. 2 is an explanatory diagram illustrating the change in open-circuit voltage of a secondary battery after discharge termination. As illustrated in Fig. 1 and Fig. 2, an open-circuit voltage 1 of a secondary battery after termination of charge and discharge converges to a constant value after a predefined lapse of time from the time of termination of charge and discharge. The time elapsed since charge and discharge of the secondary battery is terminated until convergence of the change in open-circuit voltage 1 is referred to as voltage-change convergence time $\tau$. Herein, convergence of the change in open-circuit voltage 1 denotes a state in which the change of the open-circuit voltage 1 per unit time ($dV_{OCV}/dt$) can be regarded as equal to 0. As Fig. 1 and Fig. 2 illustrate, the voltage-change convergence time $\tau$ at the time of charging termination and the voltage-change convergence time $\tau$ at the time of discharge termination are mutually different.

The inventors studied the charge and discharge characteristics of various secondary batteries, and found that the voltage-change convergence time $\tau$ changes in accordance with the temperature of the secondary battery at the time of termination of charge and discharge, as illustrated in Fig. 1 and Fig. 2. Although not illustrated in the figures, it was likewise found that the voltage-change convergence time $\tau$ depends also on the state of charge of the secondary battery at the time of termination of charge and discharge, as estimated on the basis of an integrated current value or an estimated open-circuit voltage that is worked out using a closed-circuit voltage (hereafter, integrated current value or the like). The state of charge can be estimated by working out a rate of change of the state of charge, on the basis of an integrated current value during charge and discharge, and by adding or subtracting the rate of change during charge and discharge to/from the state of charge before charge and discharge.

As is known, the time change of the open-circuit voltage 1 of the secondary battery after termination of charge and discharge can be approximated by a voltage characteristic expression, such that the open-circuit voltage 1 of a stable secondary battery can be calculated from the voltage characteristic expression and the state of charge of the secondary battery can be estimated from the open-circuit voltage 1. The inventors found that the state of charge can be estimated, using a smaller number of measured values of open-circuit voltage, by using a voltage-change convergence time $\tau$ such as described above in a voltage characteristic expression. A state-of-charge estimation method wherein the voltage-change convergence time $\tau$ is used in a voltage characteristic expression will be explained next in further detail.

Fig. 3 is an explanatory diagram illustrating a map that includes a plurality of voltage-change convergence times $\tau$ measured beforehand on the basis of the state-of-charge estimation method of the present embodiment. As described above, the voltage-change convergence time $\tau$ depends on the state of charge of the secondary battery at the time of termination of charge and discharge, as estimated on the basis of the integrated current value or the like, and on the temperature of the secondary battery at the time of termination of charge and discharge. In the state-of-charge estimation method of the present embodiment, a map such as the one illustrated in Fig. 3 is created by measuring experimentally beforehand respective voltage-change convergence times $\tau_{1-1...X-Y}$ for each combination of state of charge of the secondary battery at the time of termination of charge and discharge, as estimated on the basis of the integrated current value or the like, and temperature of the secondary battery at the time of termination of charge and discharge.

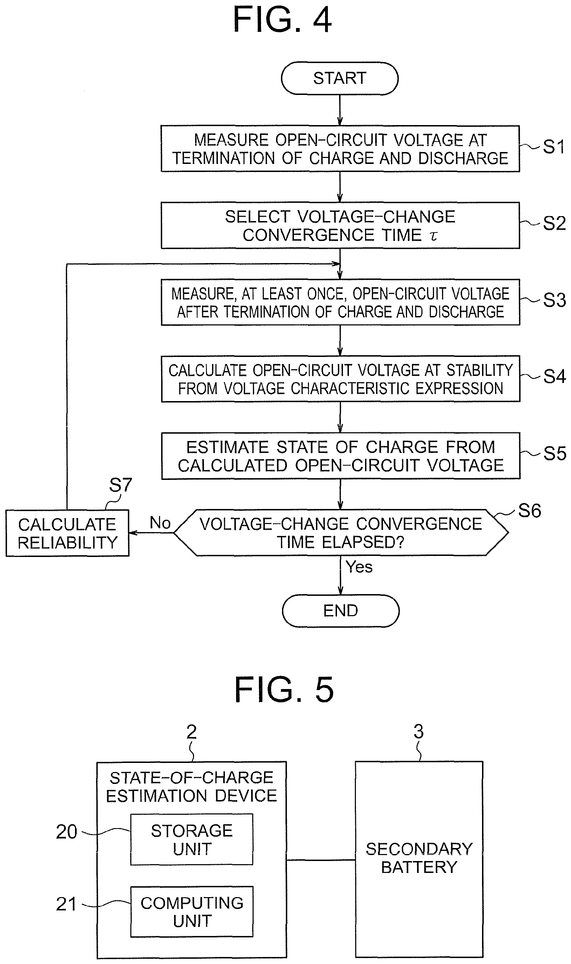

Next, Fig. 4 is a flowchart illustrating a state-of-charge estimation method after creation of the map of Fig. 3. Upon termination of charge and discharge of the secondary battery, the open-circuit voltage 1 at the time of termination of charge and discharge is measured (step S1), and a voltage-change convergence time $\tau$ corresponding to the state of charge and temperature of the secondary battery based on the integrated current value or the like at the time of termination of charge and discharge is selected from the map (step S2). Next, the open-circuit voltage 1 of the secondary battery after termination of charge and discharge is measured at least once at predefined measurement intervals, for instance of about several milliseconds to several seconds (step S3).

The open-circuit voltage 1 of the secondary battery after termination of charge and discharge is measured at least once, and thereafter, the open-circuit voltage 1 at stable secondary battery is calculated from the voltage characteristic expression (step S4), and the state of charge of the secondary battery is estimated from the calculated open-circuit voltage 1 (step S5).

The specific processes for calculating the open-circuit voltage 1 at stable secondary battery from the voltage characteristic expression will be explained next in further detail. Although various forms of voltage characteristic expression are conceivable, in the present embodiment the voltage characteristic expression is given by Expression (1) below.

$$V_{OCV}(t) = A_1 \exp(-B_1 t) + ... + A_{n+1} \exp(-B_{n+1} t) + V_C \quad ... \text{ Expression (1)}$$

In Expression (1), t is the time elapsed from the time of termination of charge and discharge, n is the number of measurements of the open-circuit voltage 1 after termination of charge and discharge, and $A_{1...n+1}$, $B_{1...n+1}$, $V_C$ are parameters that make up the voltage characteristic expression. The terms relating to time on the right of Expression (1) (terms other than $V_C$) approximate the change in the open-circuit voltage 1 after termination of charge and discharge. The term $V_C$ on the right of Expression (1) represents the open-circuit voltage 1 at stable secondary battery. The number of terms relating to time increases and decreases in accordance with the number of measurements of the open-circuit voltage after termination of charge and discharge. The more terms that relate to time, the higher the precision of the open-circuit voltage 1 as calculated on the basis of the voltage characteristic expression.

A differential expression of Expression (1) is given by Expression (2) below.

$$V'_{OCV}(t) = -B_1 A_1 \exp(-B_1 t) - ... - B_{n+1} A_{n+1} \exp(-B_{n+1} t) \quad ... \text{ Expression (2)}$$

Expression (3) below is obtained by substituting, in (1), the voltage-change convergence time $\tau$ selected in step S2.

$$V_{OCV}(\tau) = A_1 \exp(-B_1 \tau) + ... + A_{n+1} \exp(-B_{n+1} \tau) + V_C = V_C \quad ... \text{ Expression (3)}$$

The reason why the solution of Expression (3) is $V_C$ is that the open-circuit voltage converges to $V_C$ if the voltage-change convergence time $\tau$ has elapsed from the time of termination of charge and discharge.

Further, Expression (4) below is obtained by substituting in Expression (2) the voltage-change convergence time $\tau$ selected in step S2.

$$V'_{OCV}(\tau) = -B_1 A_1 \exp(-B_1 \tau) - ... - B_{n+1} A_{n+1} \exp(-B_{n+1} \tau) = 0 \quad ... \text{ Expression (4)}$$

As pointed out above, the voltage-change convergence time $\tau$ is the time elapsed from termination of the charge and discharge of the secondary battery until a state is brought about in which the change per unit time ($dV_{OCV}/dt$) can be regarded as equal to 0. In the present embodiment, accordingly, the open-circuit voltage at stability of the secondary battery is calculated from the voltage characteristic expression on the assumption that the solution of the differential expression upon substitution of the voltage-change convergence time $\tau$ in the differential expression of the voltage characteristic expression yields 0.

Further, Expression (5) below is obtained from Expression (1) and a known open-circuit voltage $V_S$ measured at the time of termination of charge and discharge (t=0).

$$V_S = V_{OCV}(0) = A_1 + ... + A_{n+1} + V_C \quad ... \text{ Expression (5)}$$

Further, Expression (6-m) below for a number of measurements n is obtained from Expression (1) and the m-th (m is an integer ranging from 1 to n) measured open-circuit voltage $V_{OCV}(t_m)$ at a time $t_m$ after termination of charge and discharge.

$$V_{OCV}(t_m) = A_1 \exp(-B_1 t_m) + ... + A_{n+1} \exp(-B_{n+1} t_m) + V_C \quad ... \text{ Expression (6-m)}$$

There is also calculated a proportion of change $V'_{OCV}(t_m)$ between two open-circuit voltages mutually adjacent in the measurement order, from among the n open-circuit voltages $V_{OCV}(t_m)$, and the open-circuit voltage $V_s$ measured at the time of termination of charge and discharge (t=0), such that Expression (7-m) for a number of measurements n is obtained from $V'_{OCV}(t_m)$ and Expression (2).

$$V'_{OCV}(t_m)=-B_1A_1exp(-B_1t_m)-...-B_{n+1}A_{n+1}\cdot exp(-B_{n+1}t_m) \quad ... \text{ Expression (7-m)}$$

The parameters $A_{1...n+1}$, $B_{1...n+1}$, $V_C$ can be established by calculating the solution of the system of equations of Expression (3), Expression (4), Expression (5), Expression (6-m) and Expression (7-m). That is, the parameter $V_C$ corresponding to the open-circuit voltage at stability of the secondary battery is calculated by calculating the solution of the system of equations.

In a hypothetical case where the number of measurements n is one, Expression (1) and Expression (2) are expressed as follows.

$$V_{OCV}(t)=A_1exp(-B_1t)+A_2exp(-B_2t)+V_C \quad ... \text{ Expression (1)}$$

$$V'_{OCV}(t)=-B_1A_1exp(-B_1t)-B_2A_2exp(-B_2t) \quad ... \text{ Expression (2)}$$

Further, Expression (3) to Expression (5) are expressed as follows.

$$V_{OCV}(\tau)=A_1exp(-B_1\tau)+A_2exp(-B_2\tau)+V_C=V_C \quad ... \text{ Expression (3)}$$

$$V'_{OCV}(\tau)=-B_1A_1exp(-B_1\tau)-B_2A_2exp(-B_2\tau)=0 \quad ... \text{ Expression (4)}$$

$$V_S=V_{OCV}(0)=A_1+A_2+V_C \quad ... \text{ Expression (5)}$$

If the number of measurements n is one, there are obtained one Expression (6-1) and one Expression (7-1) below, respectively, as the above-described Expression (6-m) and Expression (7-m),

$$V_{OCV}(t_1)=A_1exp(-B_1t_1)+A_2exp(-B_2t_1)+V_C \quad ... \text{ Expression (6-1)}$$

$$V'_{OCV}(t_1)=\{V_{OCV}(t_1)-V_S\}/t_1=-B_1A_1exp(-B_1t_1)-B_2A_2\cdot exp(-B_2t_1) \quad ... \text{ Expression (7-1)}$$

The solution of the system of equations of the five expressions (Expression (3) to Expression (7-1)) is calculated to calculate thereby the five parameters $A_1$, $A_2$, $B_1$, $B_2$, $V_C$ and estimate the state of charge of the secondary battery from the calculated $V_C$ (open-circuit voltage).

In the present embodiment, specifically, Expression (3) and Expression (4) are obtained by using the selected voltage-change convergence time $\tau$ in the voltage characteristic expression. By obtaining more expressions than in a case where the voltage-change convergence time $\tau$ is not used, it becomes possible to estimate the state of charge from fewer measured values of open-circuit voltage, and to shorten the time required for estimating the state of charge. The state of charge can obviously be estimated with yet higher precision, as compared with an instance where the voltage-change convergence time $\tau$ is not used, in a case where measured values of open-circuit voltage are used in a number identical to that when the voltage-change convergence time $\tau$ is not used.

After estimation of the state of charge of the secondary battery, it is determined whether the voltage-change convergence time $\tau$ has elapsed or not from the time of termination of charge and discharge (step S6); If it is determined that the voltage-change convergence time $\tau$ has not elapsed, the reliability of the estimated state of charge is calculated on the basis of a comparison between the time elapsed from the time of termination of charge and discharge up to the point in time when the open-circuit voltage 1 of the secondary battery is measured for the last time after termination of charge and discharge, and the voltage-change convergence time $\tau$ (step S7). Specifically, the reliability of the state of charge is calculated by computing $t_{LAST}/\tau$ where $t_{LAST}$ is the time elapsed from the time of termination of charge and discharge up to the point in time when the open-circuit voltage 1 of the secondary battery is measured for the last time after termination of charge and discharge. This is based on the idea that the open-circuit voltage 1 has converged once the voltage-change convergence time $\tau$ has elapsed, and accordingly, the estimated state of charge is trustworthy.

After reliability calculation, the above-described process of calculating the open-circuit voltage at stability from the above-described voltage characteristic expression, estimating the state of charge, and calculating reliability, is repeated until the voltage-change convergence time $\tau$ has elapsed (steps S3 to 7). The state-of-charge estimation method of the present embodiment is terminated, by contrast, if in step S6 it is determined that the voltage-change convergence time $\tau$ has elapsed. This state-of-charge estimation method is performed every time that charge and discharge of the battery is terminated. In a case where charge and discharge is resumed before the voltage-change convergence time $\tau$ has elapsed, the state-of-charge estimation method is terminated even halfway during repetition of steps S3 to 7, and the state of charge that had been estimated thus far is taken as the state of charge that is estimated in accordance with the state-of-charge estimation method of the present embodiment.

Next, Fig. 5 is a block diagram illustrating a state-of-charge estimation device for carrying out the state-of-charge estimation method of the present embodiment. In the figure, a state-of-charge estimation device 2 is connected to a secondary battery 3. For instance, the state-of-charge estimation device 2 is made up of a computer that is installed in a vehicle, and the secondary battery 3 is made up of, for instance, a lithium ion battery installed in a vehicle.

The state-of-charge estimation device 2 is provided with a storage unit 20 and a computing unit 21. The storage unit 20 is made up of, for instance, a RAM or ROM, and stores the above-described voltage-change convergence times $\tau_{1-1...X-Y}$ for each combination of state of charge of the secondary battery 3 at the time of termination of charge and discharge, as estimated on the basis of the integrated current value or the like, and temperature of the secondary battery 3 at the time of termination of charge and discharge. The computing unit 21 is made up for instance of a CPU or the like, and executes the above-described state-of-charge estimation method in accordance with a predefined program. Specifically, the operation of the computing unit 21 is as explained in Fig. 4 above.

Such a state-of-charge estimation method and state-of-charge estimation device involve measuring beforehand a voltage-change convergence time $\tau$ from termination of charge and discharge of the secondary battery until convergence of change in the open-circuit voltage 1, for each combination of state of charge of the secondary battery at the time of termination of charge and discharge, as estimated on the basis of an integrated current value or the like, and the temperature of the secondary battery at the time of termination of charge and discharge, and, upon termination of the charge and discharge of the secondary battery, selecting the voltage-change convergence time $\tau$ corresponding to the temperature and state of charge based on an integrated current value or the like at the time of termination of charge and discharge, and using the selected voltage-change convergence time $\tau$ in a voltage characteristic expression. Therefore, it becomes possible to estimate the state of charge using a smaller number of measured values of open-circuit voltage, and to shorten the time required for estimation of the state of charge. The state of charge can be estimated with yet higher precision, as compared with an instance where the voltage-change convergence time $\tau$ is not used, in a case where measured values of open-circuit voltage are used in a number identical to that when the voltage-change convergence time $\tau$ is not used.

The open-circuit voltage at stability of the secondary battery is calculated from the voltage characteristic expression by exploiting the feature whereby, upon substitution of the voltage-change convergence time $\tau$ in the differential expression of the voltage characteristic expression, the solution of the differential expression is 0. Therefore, this allows more expressions pertaining to a voltage characteristic expression to be obtained, and allows the state of charge to be estimated using a smaller number of measured values of open-circuit voltage.

Further, the open-circuit voltage at stability of the secondary battery is calculated from the voltage characteristic expression by using the measured open-circuit voltage of the secondary battery, and further using a proportion of change of open-circuit voltage between measured open-circuit voltages of the secondary battery. Therefore, the open-circuit voltage at stability can be calculated yet more reliably.

The parameter $V_C$ corresponding to the open-circuit voltage at stability of the secondary battery is calculated as a result of the process explained in the embodiment, and hence the open-circuit voltage at stability can be calculated even more reliably.

Further, the reliability of the estimated state of charge is calculated on the basis of a comparison between the voltage-change convergence time $\tau$ and the time elapsed from the time of termination of charge and discharge up to the point in time when the open-circuit voltage of the secondary battery is measured for the last time after termination of charge and discharge. Therefore, it becomes possible to obtain a yardstick on the degree of reliability of the estimated state of charge.

**Claims**

1. A state-of-charge estimation method for estimating a state of charge of a secondary battery (3) by approximating a time change in an open-circuit voltage of the secondary battery after termination of charge and discharge by a voltage characteristic expression, and calculating the open-circuit voltage from the voltage characteristic expression where the secondary battery is stable,
   the method comprising the steps of:

   measuring beforehand a voltage-change convergence time $\tau$ from termination of charge and discharge of the secondary battery until convergence of change in the open-circuit voltage, for each combination of an estimated state of charge of the secondary battery at the time of termination of charge and discharge and the temperature of the secondary battery at the time of termination of charge and discharge; and
   upon termination of charge and discharge of the secondary battery, selecting (S2) the voltage-change convergence time $\tau$ corresponding to the estimated state of charge and the temperature at the time of termination of charge and discharge, and using the selected voltage-change convergence time $\tau$ in the voltage characteristic expression, **characterized in that**
   the convergence of the change in the open-circuit voltage denotes a state in which the change of the open-circuit voltage per unit time can be regarded as equal to 0.

2. The state-of-charge estimation method according to claim 1, wherein the voltage-change convergence time $\tau$ is substituted in a differential expression of the voltage characteristic expression, to calculate the open-circuit voltage at stability of the secondary battery.

3. The state-of-charge estimation method according to claim 2, wherein
   the open-circuit voltage of the secondary battery is measured (S1) at the time of termination of charge and discharge, and the open-circuit voltage of the secondary battery after termination of charge and discharge is measured (S3) at least once; and
   the open-circuit voltage at stability of the secondary battery is calculated (S4) from the voltage characteristic expression by further using the measured open-circuit voltages of the secondary battery and a proportion of change in open-circuit voltage between measured open-circuit voltages of the secondary battery.

4. The state-of-charge estimation method according to claim 3, wherein
   the voltage characteristic expression is expressed by Expression (1) below, which includes parameters $A_{1...n+1}$, $B_{1...n+1}$, $V_C$, where t denotes the time elapsed from the time of termination of charge and discharge, and n denotes the number of measurements of the open-circuit voltage after termination of charge and discharge:

$$V_{OCV}(t)=A_1\exp(-B_1 t)+...+A_{n+1}\exp(-B_{n+1} t)+V_C... \text{ Expression (1)}$$

the differential expression is expressed by Expression (2) below:

$$V'_{OCV}(t)=-B_1 A_1\exp(-B_1 t)-...-B_{n+1}A_{n+1}\exp(-B_{n+1} t)... \text{ Expression (2)}$$

Expression (3) and Expression (4) below are obtained by substituting $\tau$ in the Expression (1) and the Expression (2):

$$V_{OCV}(\tau)=A_1\exp(-B_1\tau)+...+A_{n+1}\exp(-B_{n+1}\tau)+V_C=V_C... \text{ Expression (3)}$$

$$V'_{OCV}(\tau)=-B_1 A_1\exp(-B_1\tau)-...-B_{n+1}A_{n+1}\exp(-B_{n+1}\tau)=0... \text{ Expression (4)}$$

Expression (5) below is obtained from the Expression (1) and a known open-circuit voltage $V_S$ measured at the time of termination of charge and discharge (t=0):

$$V_S=V_{OCV}(0)=A_1+...+A_{n+1}+V_C... \text{ Expression (5)}$$

Expression (6-m) below for the number of measurements n is obtained from Expression (1) and an m-th (m is an integer ranging from 1 to n) measured open-circuit voltage $V_{OCV}(t_m)$ at a time $t_m$ after termination of charge and discharge:

$$V_{OCV}(t_m)=A_1\exp(-B_1t_m)+...+A_{n+1}\exp(-B_{n+1}t_m)+V_C... \text{ Expression (6-m)}$$

Expression (7-m) below for the number of measurements n is obtained from the open-circuit voltage $V_s$, a proportion of change $V'_{OCV}(t_m)$ between two open-circuit voltages mutually adjacent in a measurement order, from among the n open-circuit voltages $V_{OCV}(t_m)$, and the Expression (2):

$$V'_{OCV}(t_m)=-B_1A_1\exp(-B_1t_m)-...-B_{n+1}A_{n+1}\cdot\exp(-B_{n+1}t_m)... \text{ Expression (7-m),}$$

and
the parameter $V_C$ corresponding to the open-circuit voltage at stability of the secondary battery is calculated by solving the system of equations of Expression (3), Expression (4), Expression (5), Expression (6-m) and Expression (7-m).

5. The state-of-charge estimation method according to claim 3 or 4, wherein
measurement of the open-circuit voltage of the secondary battery after termination of charge and discharge is performed at predefined measurement intervals; and
reliability of the estimated state of charge is calculated on the basis of a comparison between the time elapsed from the time of termination of charge and discharge up to the point in time when the open-circuit voltage of the secondary battery is measured for a last time after termination of charge and discharge, and the voltage-change convergence time $\tau$.

6. A state-of-charge estimation device (2) configured to calculate an open-circuit voltage from a voltage characteristic expression where a secondary battery (3) is at stable in which a time change of open-circuit voltage of the secondary battery is approximated after termination of charge and discharge, in order to estimate the state of charge of the secondary battery (3),
the device (2) comprising:

a storage unit (20) configured to store a voltage-change convergence time $\tau$ from termination of charge and discharge of the secondary battery until convergence of change in the open-circuit voltage, for each combination of an estimated state of charge of the secondary battery at the time of termination of charge and discharge and the temperature of the secondary battery at the time of termination of charge and discharge; and
a computing unit (21) configured to select, upon termination of charge and discharge of the secondary battery, the voltage-change convergence time $\tau$ corresponding to the estimated state of charge and the temperature at the time of termination of charge and discharge, and to use the selected voltage-change convergence time $\tau$ in the voltage characteristic
expression, **characterized in that**
the convergence of the change in the open-circuit voltage denotes a state in which the change of the open-circuit voltage per unit time can be regarded as equal to 0.

7. The state-of-charge estimation device according to claim 6, wherein the computing unit is configured to substitute the voltage-change convergence time $\tau$ in a differential expression of the voltage characteristic expression, to calculate the open-circuit voltage at stability of the secondary battery.

8. The state-of-charge estimation device according to claim 7, wherein
the computing unit is configured to
measure the open-circuit voltage of the secondary battery at the time of termination of charge and discharge, and measure the open-circuit voltage of the secondary battery after termination of charge and discharge at least once; and calculate the open-circuit voltage at stability of the secondary battery from the voltage characteristic expression by further using the measured open-circuit voltages of the secondary battery and a proportion of change in open-circuit voltage between measured open-circuit voltages of the secondary battery.

9. The state-of-charge estimation device according to claim 8, wherein
the voltage characteristic expression is expressed by Expression (1) below, which includes parameters $A_{1\ldots n+1}$, $B_{1\ldots n+1}$, $V_C$, where t denotes the time elapsed from the time of termination of charge and discharge, and n denotes the number of measurements of the open-circuit voltage after termination of charge and discharge:

$$V_{OCV}(t)=A_1\exp(-B_1 t)+\ldots+A_{n+1}\exp(-B_{n+1} t)+V_C\ldots \text{ Expression (1)}$$

the differential expression is expressed by Expression (2) below:

$$V'_{OCV}(t)=-B_1 A_1\exp(-B_1 t)-\ldots-B_{n+1}A_{n+1}\exp(-B_{n+1} t)\ldots \text{ Expression (2),}$$

and wherein
the computing unit is configured to
obtain Expression (3) and Expression (4) below by substituting $\tau$ in the Expression (1) and the Expression (2):

$$V_{OCV}(\tau)=A_1\exp(-B_1\tau)+\ldots+A_{n+1}\exp(-B_{n+1}\tau)+V_C=V_C\ldots \text{ Expression (3)}$$

$$V'_{OCV}(\tau)=-B_1 A_1\exp(-B_1\tau)-\ldots-B_{n+1}A_{n+1}\exp(-B_{n+1}\tau)=0\ldots \text{ Expression (4)}$$

obtain Expression (5) below from the Expression (1) and a known open-circuit voltage $V_S$ measured at the time of termination of charge and discharge (t=0):

$$V_S=V_{OCV}(0)=A_1+\ldots+A_{n+1}+V_C\ldots \text{ Expression (5)}$$

obtain Expression (6-m) below for the number of measurements n from Expression (1) and an m-th (m is an integer ranging from 1 to n) measured open-circuit voltage $V_{OCV}(t_m)$ at a time $t_m$ after termination of charge and discharge:

$$V_{OCV}(t_m)=A_1\exp(-B_1 t_m)+\ldots+A_{n+1}\exp(-B_{n+1} t_m)+V_C\ldots \text{ Expression (6-m)}$$

obtain Expression (7-m) below for the number of measurements n from the open-circuit voltage $V_s$, a proportion of change $V'_{OCV}(t_m)$ between two open-circuit voltages mutually adjacent in a measurement order, from among the n open-circuit voltages $V_{OCV}(t_m)$, and the Expression (2):

$$V'_{OCV}(t_m)=-B_1 A_1\exp(-B_1 t_m)-\ldots-B_{n+1}A_{n+1}\cdot\exp(-B_{n+1} t_m)\ldots \text{ Expression (7-nd}$$

and
calculate the parameter $V_C$ corresponding to the open-circuit voltage at stability of the secondary battery by solving a system of equations of Expression (3), Expression (4), Expression (5), Expression (6-m) and Expression (7-m).

10. The state-of-charge estimation device according to claim 8 or 9, wherein the computing unit is configured to
measure of the open-circuit voltage of the secondary battery after termination of charge and discharge is performed at predefined measurement intervals; and
calculate reliability of the estimated state of charge on the basis of a comparison between the voltage-change convergence time $\tau$ and the time elapsed from the time of termination of charge and discharge up to the point in time when the open-circuit voltage of the secondary battery is measured for a last time after termination of charge and discharge.

**Patentansprüche**

1.  Ladezustandsschätzverfahren zum Schätzen eines Ladezustands einer Sekundärbatterie (3) durch, nach Beenden des Ladens und Entladens, Approximieren einer zeitlichen Änderung einer Leerlaufspannung der Sekundärbatterie durch einen Spannungskennlinienausdruck, und Berechnen der Leerlaufspannung aus dem Spannungskennlinienausdruck, in dem die Sekundärbatterie stabil ist,
    wobei das Verfahren die Schritte umfasst:

    vorab Messen einer Spannungsänderungskonvergenzzeit $\tau$ von dem Beenden des Ladens und Entladens der Sekundärbatterie bis zum Konvergieren der Änderung der Leerlaufspannung, für jede Kombination eines geschätzten Ladezustands der Sekundärbatterie zum Zeitpunkt des Beendens des Ladens und Entladens und der Temperatur der Sekundärbatterie zum Zeitpunkt des Beendens des Ladens und Entladens; und
    nach Beenden des Ladens und Entladens der Sekundärbatterie, Auswählen (S2) der Spannungsänderungskonvergenzzeit $\tau$ entsprechend des geschätzten Ladezustands und der Temperatur zum Zeitpunkt des Beendens des Ladens und Entladens, und Verwenden der ausgewählten Spannungsänderungskonvergenzzeit $\tau$ in dem Spannungskennlinienausdruck,
    **dadurch gekennzeichnet, dass**
    die Konvergenz der Änderung in der Leerlaufspannung einen Zustand bezeichnet, in dem die Änderung der Leerlaufspannung pro Zeiteinheit als gleich 0 angesehen werden kann.

2.  Ladezustandsschätzverfahren gemäß Anspruch 1, wobei die Spannungsänderungskonvergenzzeit $\tau$ durch einen Differentialausdruck des Spannungskennlinienausdrucks substituiert wird, um die Leerlaufspannung bei Stabilität der Sekundärbatterie zu berechnen.

3.  Ladezustandsschätzverfahren gemäß Anspruch 2, wobei
    die Leerlaufspannung der Sekundärbatterie zum Zeitpunkt des Beendens des Ladens und Entladens gemessen (S1) wird, und die Leerlaufspannung der Sekundärbatterie nach Beenden des Ladens und Entladens zumindest einmal gemessen (S3) wird; und
    die Leerlaufspannung bei Stabilität der Sekundärbatterie aus dem Spannungskennlinienausdruck berechnet (S4) wird, indem zudem die gemessenen Leerlaufspannungen der Sekundärbatterie und ein Anteil einer Änderung der Leerlaufspannung zwischen gemessenen Leerlaufspannungen der Sekundärbatterie verwendet werden.

4.  Ladezustandsschätzverfahren gemäß Anspruch 3, wobei der Spannungskennlinienausdruck durch den folgenden Ausdruck (1), der die Parameter $A_{1...n+1}$, $B_{1...n+1}$, $V_C$ umfasst, ausgedrückt wird, wobei $t$ die seit dem Zeitpunkt des Beendens des Ladens und Entladens verstrichene Zeit bezeichnet, und $n$ die Anzahl der Messungen der Leerlaufspannung nach Beenden des Ladens und Entladens bezeichnet:

$$V_{OCV}(t) = A_1 \exp(-B_1 t) + ... + A_{n+1} \exp(-B_{n+1} t) + V_C ... \text{ Ausdruck (1)}$$

wobei der Differentialausdruck durch folgenden Ausdruck (2) ausgedrückt ist:

$$V'_{OCV}(t) = -B_1 A_1 \exp(-B_1 t) - ... - B_{n+1} A_{n+1} \exp(-B_{n+1} t) ... \text{ Ausdruck (2)}$$

nachstehender Ausdruck (3) und Ausdruck (4) durch Substituieren von $\tau$ im Ausdruck (1) und im Ausdruck (2) erlangt werden:

$$V_{OCV}(\tau) = A_1 \exp(-B_1 \tau) + ... + A_{n+1} \exp(-B_{n+1} \tau) + V_C = V_C ... \text{ Ausdruck (3)}$$

$$V'_{OCV}(\tau) = -B_1 A_1 \exp(-B_1 \tau) - ... - B_{n+1} A_{n+1} \exp(-B_{n+1} \tau) = 0 ... \text{ Ausdruck (4)}$$

Ausdruck (5) im Folgenden aus dem Ausdruck (1) und einer bekannten Leerlaufspannung $V_S$ erlangt wird, die zum Zeitpunkt des Beendens des Ladens und Entladens ($t=0$) gemessen wird:

$$V_S = V_{OCV}(0) = A_1 + ... + A_{n+1} + V_C ... \text{ Ausdruck (5)}$$

nachstehender Ausdruck (6-m) für die Anzahl an Messungen n aus Ausdruck (1) und einer m-ten (m ist eine ganze Zahl im Bereich von 1 bis n) gemessenen Leerlaufspannung $V_{OCV}(t_m)$ zum Zeitpunkt $t_m$ nach Beenden des Ladens und Entladens erlangt wird:

$$V_{OCV}(t_m) = A_1 \exp(-B_1 t_m) + ... + A_{n+1} \exp(-B_{n+1} t_m) + V_C ... \text{ Ausdruck (6-m)}$$

Ausdruck (7-m) im Folgenden für die Anzahl an Messungen n aus der Leerlaufspannung $V_S$, einem Anteil der Änderung $V'_{OCV}(t_m)$ zwischen zwei anschließenden Leerlaufspannungen in einer Messreihe aus den n Leerlaufspannungen $V_{OCV}(t_m)$, und dem Ausdruck (2) erlangt wird:

$$V'_{OCV}(t_m) = -B_1 A_1 \exp(-B_1 t_m) - ... - B_{n+1} A_{n+1} \cdot \exp(-B_{n+1} t_m) ... \text{ Ausdruck (7-m),}$$

und
der Parameter $V_C$, entsprechend der Leerlaufspannung bei Stabilität der Sekundärbatterie durch Lösen des Gleichungssystems aus Ausdruck (3), Ausdruck (4), Ausdruck (5), Ausdruck (6-m) und Ausdruck (7-m) berechnet wird.

5. Ladezustandsschätzverfahren gemäß Anspruch 3 oder 4, wobei
das Messen der Leerlaufspannung der Sekundärbatterie nach Beenden des Ladens und Entladens in vordefinierten Messintervallen durchgeführt wird; und
die Zuverlässigkeit des geschätzten Ladezustands, basierend auf einem Vergleich zwischen der Spannungsänderungskonvergenzzeit $\tau$ und der verstrichenen Zeit vom Zeitpunkt des Beendens des Ladens und Entladens bis zu dem Zeitpunkt, zudem die Leerlaufspannung der Sekundärbatterie zum letzten Mal nach Beenden des Ladens und Entladens gemessen wird, berechnet wird.

6. Ladezustandsschätzvorrichtung (2), die dazu eingerichtet ist, um aus einem Spannungskennlinienausdruck, in dem eine Sekundärbatterie (3) stabil ist, eine Leerlaufspannung zu berechnen, in welcher eine zeitliche Änderung der Leerlaufspannung der Sekundärbatterie nach Beendigung des Ladens und Entladens approximiert ist, um den Ladezustand der Sekundärbatterie (3) zu schätzen,
die Vorrichtung (2) umfasst:

eine Speichereinheit (20), die dazu eingerichtet ist, um eine Spannungsänderungskonvergenzzeit $\tau$ von der Beendigung des Ladens und Entladens der Sekundärbatterie bis zur Konvergenz der Änderung der Leerlaufspannung zu speichern, für jede Kombination eines geschätzten Ladezustands der Sekundärbatterie zum Zeitpunkt der Beendigung des Ladens und Entladens und der Temperatur der Sekundärbatterie zum Zeitpunkt der Beendigung des Ladens und Entladens; und
eine Berechnungseinheit (21), die dazu eingerichtet ist, um nach Beendigung des Ladens und Entladens der Sekundärbatterie die Spannungsänderungskonvergenzzeit $\tau$ entsprechend des geschätzten Ladezustands und der Temperatur zum Zeitpunkt der Beendigung des Ladens und Entladens auszuwählen, und um die ausgewählte Spannungsänderungskonvergenzzeit $\tau$ in dem Spannungskennlinienausdruck zu verwenden,
**dadurch kennzeichnet, dass**
die Konvergenz der Änderung in der Leerlaufspannung einen Zustand bezeichnet, in dem die Änderung der Leerlaufspannung pro Zeiteinheit als gleich 0 angesehen werden kann.

7. Ladezustandsschätzvorrichtung gemäß Anspruch 6, wobei die Berechnungseinheit dazu eingerichtet ist, um die Spannungsänderungskonvergenzzeit $\tau$ durch einen Differentialausdruck des Spannungskennlinienausdrucks zu substituieren, um die Leerlaufspannung bei Stabilität der Sekundärbatterie zu berechnen.

8. Ladezustandsschätzvorrichtung gemäß Anspruch 7, wobei die Berechnungseinheit dazu eingerichtet ist, um
die Leerlaufspannung der Sekundärbatterie zum Zeitpunkt der Beendigung des Ladens und Entladens zu messen, und die Leerlaufspannung der Sekundärbatterie nach Beendigung des Ladens und Entladens zumindest einmal zu messen; und
die Leerlaufspannung bei Stabilität der Sekundärbatterie aus dem Spannungskennlinienausdruck zu berechnen, indem zudem die gemessenen Leerlaufspannungen der Sekundärbatterie und eine Änderung des Anteils der Leerlaufspannung zwischen gemessenen Leerlaufspannungen der Sekundärbatterie verwendet werden.

9. Ladezustandsschätzvorrichtung gemäß Anspruch 8, wobei
der Spannungskennlinienausdruck durch den folgenden Ausdruck (1), der die Parameter $A_{1...n+1}$, $B_{1...n+1}$, $V_C$ umfasst, ausgedrückt ist, wobei t die seit dem Zeitpunkt der Beendigung des Ladens und Entladens verstrichene Zeit bezeichnet, und n die Anzahl der Messungen der Leerlaufspannung nach Beendigung des Ladens und Entladens bezeichnet:

$$V_{OCV}(t)=A_1\exp(-B_1 t)+…+A_{n+1}\exp(-B_{n+1}t)+V_C… \text{ Ausdruck (1)}$$

wobei der Differentialausdruck durch folgenden Ausdruck (2) ausgedrückt ist:

$$V'_{OCV}(t)=-B_1 A_1\exp(-B_1 t)-…-B_{n+1}A_{n+1}\exp(-B_{n+1}t)… \text{ Ausdruck (2),}$$

und wobei
die Berechnungseinheit dazu eingerichtet ist, um
den Ausdruck (3) und den Ausdruck (4) im Folgenden durch Substituierung von $\tau$ im Ausdruck (1) und im Ausdruck (2) zu erlangen:

$$V_{OCV}(\tau)=A_1\exp(-B_1\tau)+…+A_{n+1}\exp(-B_{n+1}\tau)+V_{C=}\ V_C… \text{ Ausdruck (3)}$$

$$V'_{OCV}(\tau)=-B_1 A_1\exp(-B_1\tau)-…-B_{n+1}A_{n+1}\exp(-B_{n+1}\tau)=0… \text{ Ausdruck (4)}$$

den nachstehenden Ausdruck (5) aus dem Ausdruck (1) und einer bekannten Leerlaufspannung $V_S$, die zum Zeitpunkt der Beendigung des Ladens und Entladens (t=0) gemessen wird, zu erlangen:

$$V_S=V_{OCV}(0)=A_1+…+A_{n+1}+V_C… \text{ Ausdruck (5)}$$

den Ausdruck (6-m) im Folgenden für die Anzahl an Messungen n aus Ausdruck (1) und einer m-ten (m ist eine ganze Zahl im Bereich von 1 bis n) gemessenen Leerlaufspannung $V_{OCV}(t_m)$ zum Zeitpunkt $t_m$ nach Beendigung des Ladens und Entladens zu erlangen:

$$V_{OCV}(t_m)=A_1\exp(-B_1 t_m)+…+A_{n+1}\exp(-B_{n+1}t_m)+V_C… \text{ Ausdruck (6-m)}$$

den nachstehenden Ausdruck (7-m) für die Anzahl an Messungen n aus der Leerlaufspannung $V_S$, einem Anteil der Änderung $V'_{OCV}(t_m)$ zwischen zwei anschließenden Leerlaufspannungen in einer Messreihe aus den n Leerlaufspannungen $V_{OCV}(t_m)$, und dem Ausdruck (2) zu erlangen:

$$V'_{OCV}(t_m)=-B_1 A_1\exp(-B_1 t_m)-…-B_{n+1}A_{n+1}\cdot\exp(-B_{n+1}t_m)… \text{ Ausdruck (7-m),}$$

und
den Parameter $V_C$, entsprechend der Leerlaufspannung bei Stabilität der Sekundärbatterie durch Lösung des Gleichungssystems aus Ausdruck (3), Ausdruck (4), Ausdruck (5), Ausdruck (6-m) und Ausdruck (7-m) zu berechnen.

10. Ladezustandsschätzvorrichtung gemäß Anspruch 8 oder 9, wobei die Berechnungseinheit dazu eingerichtet ist, um
die Leerlaufspannung der Sekundärbatterie nach Beendigung des in vordefinierten Messintervallen durchgeführten Ladens und Entladens zu messen; und
die Zuverlässigkeit des geschätzten Ladezustands, basierend auf einem Vergleich zwischen der Spannungsänderungskonvergenzzeit $\tau$ und der verstrichenen Zeit vom Zeitpunkt der Beendigung des Ladens und Entladens bis zu dem Zeitpunkt, zu dem die Leerlaufspannung der Sekundärbatterie zum letzten Mal nach Beendigung des Ladens und Entladens gemessen wird, zu berechnen.

**Revendications**

1.  Procédé d'estimation d'un état de charge destiné à estimer un état de charge d'une batterie secondaire (3) en approximant un changement de durée d'une tension de circuit ouvert de la batterie secondaire après la fin de la charge et de la décharge à l'aide d'une expression de caractéristique de tension, et à calculer la tension de circuit ouvert à partir de l'expression de caractéristique de tension dans laquelle la batterie secondaire est stable, dans lequel le procédé comprend les étapes qui consistent à :

    mesurer à l'avance une durée de convergence de changement de tension $\tau$ à partir de la fin de la charge et de la décharge de la batterie secondaire, jusqu'à la convergence du changement de tension de circuit ouvert, pour chaque combinaison d'un état de charge estimé de la batterie secondaire au moment de la fin de la charge et de la décharge et de la température de la batterie secondaire au moment de la fin de la charge et de la décharge ; et

    à la fin de la charge et de la décharge de la batterie secondaire, sélectionner (S2) la durée de convergence de changement de tension $\tau$ qui correspond à l'état de charge estimé et à la température au moment de la fin de la charge et de la décharge, et utiliser la durée de convergence de changement de tension sélectionnée $\tau$ dans l'expression de caractéristique de tension, **caractérisé en ce que**

    la convergence du changement de tension de circuit ouvert indique un état dans lequel le changement de tension de circuit ouvert par unité de temps peut être considéré comme égal à 0.

2.  Procédé d'estimation d'un état de charge selon la revendication 1, dans lequel la durée de convergence de changement de tension $\tau$ est remplacée dans une expression différentielle de l'expression de caractéristique de tension, afin de calculer la tension de circuit ouvert en cas de stabilité de la batterie secondaire.

3.  Procédé d'estimation d'un état de charge selon la revendication 2, dans lequel
    la tension de circuit ouvert de la batterie secondaire est mesurée (S1) au moment de la fin de la charge et de la décharge, et la tension de circuit ouvert de la batterie secondaire après la fin de la charge et de la décharge est mesurée (S3) au moins une fois ; et
    la tension de circuit ouvert en cas de stabilité de la batterie secondaire est calculée (S4) à partir de l'expression de caractéristique de tension en utilisant les tensions de circuit ouvert mesurées de la batterie secondaire et une proportion de changement de tension de circuit ouvert entre les tensions de circuit ouvert mesurées de la batterie secondaire.

4.  Procédé d'estimation d'un état de charge selon la revendication 3, dans lequel
    l'expression de caractéristique de tension est exprimée par l'expression (1) ci-dessous, qui comprend des paramètres $A_{1...n+1}$, $B_{1...n+1}$, $V_c$, où t indique la durée écoulée entre le moment de fin de la charge et de la décharge, et n indique le nombre de mesures de la tension de circuit ouvert après la fin de la charge et de la décharge :

    $$V_{ocv}(t) = A_1 \exp(-B_1 t) + \ldots + A_{n+1} \exp(-B_{n+1}t) + V_C \ldots \text{ Expression (1)}$$

    l'expression différentielle est exprimée par l'expression (2) ci-dessous :

    $$V'_{ocv}(t) = -B_1 A_1 \exp(-B_1 t) - \ldots - B_{n+1} A_{n+1} \exp(-B_{n+1}t) \ldots \text{ Expression (2)}$$

    L'expression (3) et l'expression (4) ci-dessous sont obtenues en remplaçant $\tau$ dans l'expression (1) et l'expression (2) :

    $$V_{ocv}(\tau) = A_1 \exp(-B_1 \tau) + \ldots + A_{n+1} \exp(-B_{n+1}\tau) + V_C = V_C \ldots \text{ Expression (3)}$$

    $$V'_{ocv}(\tau) = -B_1 A_1 \exp(-B_1 \tau) - \ldots - B_{n+1} A_{n+1} \exp(-B_{n+1}\tau) = 0 \ldots \text{ Expression (4)}$$

    L'expression (5) ci-dessous est obtenue à partir de l'expression (1) et d'une tension de circuit ouvert connue $V_s$ mesurée au moment de la fin de la charge et de la décharge (t=0) :

$$V_S = V_{OCV}(0) = A_1 + \ldots + A_{n+1} + V_C \ldots \text{ Expression (5)}$$

L'expression (6-m) ci-dessous pour le nombre de mesures n est obtenue à partir de l'expression (1) et d'une m-ième (m est un entier compris entre 1 et n) tension de circuit ouvert $V_{OCV}(t_m)$ mesurée à un moment $t_m$ après la fin de la charge et de la décharge :

$$V_{OCV}(t_m) = A_1 \exp(-B_1 t_m) + \ldots + A_{n+1} \exp(-B_{n+1} t_m) + V_C \ldots \text{ Expression (6-m)}$$

L'expression (7-m) ci-dessous pour le nombre de mesures n est obtenue à partir de la tension de circuit ouvert $V_s$, d'une proportion de changement $V'_{ocv}(t_m)$ entre deux tensions de circuit ouvert mutuellement adjacentes dans un ordre de mesure, parmi les n tensions de circuit ouvert $V_{ocv}(t_m)$, et de l'expression (2) :

$$V'_{OCV}(t_m) = -B_1 A_1 \exp(-B_1 t_m) - \ldots - B_{n+1} A_{n+1} \cdot \exp(-B_{n+1} t_m) \ldots \text{ Expression } (7\text{-m}),$$

et

le paramètre $V_c$ qui correspond à la tension de circuit ouvert en cas de stabilité de la batterie secondaire est calculé en résolvant le système d'équations de l'expression (3), de l'expression (4), de l'expression (5), de l'expression (6-m) et de l'expression (7-m).

5. Procédé d'estimation d'un état de charge selon la revendication 3 ou 4, dans lequel
la mesure de la tension de circuit ouvert de la batterie secondaire après la fin de la charge et de la décharge est effectuée à des intervalles de mesure prédéfinis ; et
la fiabilité de l'état de charge estimé est calculée sur la base d'une comparaison entre la durée écoulée entre le moment de fin de la charge et de la décharge et le moment auquel la tension de circuit ouvert de la batterie secondaire est mesurée une dernière fois après la fin de la charge et de la décharge, et de la durée de convergence de changement de tension $\tau$.

6. Dispositif d'estimation d'un état de charge (2) configuré pour calculer une tension de circuit ouvert à partir d'une expression de caractéristique de tension dans laquelle une batterie secondaire (3) est stable, dans lequel un changement de durée d'une tension de circuit ouvert de la batterie secondaire est approximé après la fin de la charge et de la décharge, afin d'estimer l'état de charge de la batterie secondaire (3),
dans lequel le dispositif (2) comprend :

une unité de stockage (20) configurée pour stocker une durée de convergence de changement de tension $\tau$ à partir de la fin de la charge et de la décharge de la batterie secondaire, jusqu'à la convergence du changement de tension de circuit ouvert, pour chaque combinaison d'un état de charge estimé de la batterie secondaire à la fin de la charge et de la décharge et de la température de la batterie secondaire à la fin de la charge et de la décharge ; et
une unité de calcul (21) configurée pour sélectionner, à la fin de la charge et de la décharge de la batterie secondaire, la durée de convergence de changement de tension $\tau$ qui correspond à l'état de charge estimé et à la température à la fin de la charge et de la décharge, et pour utiliser la durée de convergence de changement de tension sélectionnée $\tau$ dans l'expression de caractéristique de tension, **caractérisé en ce que**
la convergence du changement de tension de circuit ouvert indique un état dans lequel le changement de tension de circuit ouvert peut être considéré comme étant à zéro.

7. Dispositif d'estimation d'un état de charge selon la revendication 6, dans lequel l'unité de calcul est configurée pour remplacer la durée de convergence de changement de tension $\tau$ dans une expression différentielle de l'expression de caractéristique de tension, afin de calculer la tension de circuit ouvert en cas de stabilité de la batterie secondaire.

8. Dispositif d'estimation d'un état de charge selon la revendication 7, dans lequel
l'unité de calcul est configurée pour
mesurer la tension de circuit ouvert de la batterie secondaire à la fin de la charge et de la décharge, et mesurer la tension de circuit ouvert de la batterie secondaire après la fin de la charge et de la décharge, au moins une fois ; et
pour calculer la tension de circuit ouvert en cas de stabilité de la batterie secondaire à partir de l'expression de caractéristique de tension en utilisant les tensions de circuit ouvert mesurées de la batterie secondaire et une proportion de changement de la tension de circuit ouvert entre les tensions de circuit ouvert mesurées de la batterie secondaire.

9.  Dispositif d'estimation d'un état de charge selon la revendication 8, dans lequel
    l'expression de caractéristique de tension est exprimée par l'expression (1) ci-dessous, qui comprend des paramètres $A_{1...n+1}$, $B_{1...n+1}$, $V_c$, où t indique la durée écoulée entre le moment de fin de la charge et de la décharge, et n indique le nombre de mesures de la tension de circuit ouvert après la fin de la charge et de la décharge :

    $$V_{OCV}(t)=A_1\exp(-B_1 t)+...+A_{n+1}\exp(-B_{n+1}t)+V_C...\text{ Expression (1)}$$

    l'expression différentielle est exprimée par l'expression (2) ci-dessous :

    $$V'_{OCV}(t)=-B_1 A_1\exp(-B_1 t)-...-B_{n+1}A_{n+1}\exp(-B_{n+1}t)...\text{ Expression (2)},$$

    et dans lequel
    l'unité de calcul est configurée pour
    obtenir l'expression (3) et l'expression (4) ci-dessous en remplaçant $\tau$ dans l'expression (1) et l'expression (2) :

    $$V_{OCV}(\tau)=A_1\exp(-B_1\tau)+...+A_{n+1}\exp(-B_{n+1}\tau)+V_C=V_C...\text{ Expression (3)}$$

    $$V'_{OCV}(\tau)=-B_1 A_1\exp(-B_1\tau)-...-B_{n+1}A_{n+1}\exp(-B_{n+1}\tau)=0...\text{ Expression (4)}$$

    obtenir l'expression (5) ci-dessous à partir de l'expression (1) et d'une tension de circuit ouvert connue $V_s$ mesurée au moment de la fin de la charge et de la décharge (t=0) :

    $$V_S=V_{OCV}(0)=A_1+...+A_{n+1}+V_C...\text{ Expression (5)}$$

    obtenir l'expression (6-m) ci-dessous pour le nombre de mesures n à partir de l'expression (1) et d'une m-ième (m est un entier compris entre 1 et n) tension de circuit ouvert $V_{OCV}(t_m)$ mesurée à un moment $t_m$ après la fin de la charge et de la décharge :

    $$V_{OCV}(t_m)=A_1\exp(-B_1 t_m)+...+A_{n+1}\exp(-B_{n+1}t_m)+V_C...\text{ Expression (6-m)}$$

    obtenir l'expression (7-m) ci-dessous pour le nombre de mesures n à partir de la tension de circuit ouvert $V_s$, d'une proportion de changement $V'_{ocv}(t_m)$ entre deux tensions de circuit ouvert mutuellement adjacentes dans un ordre de mesure, parmi les n tensions de circuit ouvert $V_{ocv}(t_m)$, et de l'expression (2) :

    $$V'_{OCV}(t_m)=-B_1 A_1\exp(-B_1 t_m)-...-B_{n+1}A_{n+1}\cdot\exp(-B_{n+1}t_m)...\text{ Expression (7-m)},$$

    et
    calculer le paramètre $V_c$ qui correspond à la tension de circuit ouvert en cas de stabilité de la batterie secondaire en résolvant un système d'équations de l'expression (3), de l'expression (4), de l'expression (5), de l'expression (6-m) et de l'expression (7-m).

10. Dispositif d'estimation d'un état de charge selon la revendication 8 ou 9, dans lequel l'unité de calcul est configurée pour mesurer la tension de circuit ouvert de la batterie secondaire après la fin de la charge et de la décharge à des intervalles de mesure prédéfinis ; et
    calculer la fiabilité de l'état de charge estimé sur la base d'une comparaison entre la durée de convergence de changement de tension $\tau$ et la durée écoulée entre la fin de la charge et de la décharge et le moment auquel la tension de circuit ouvert de la batterie secondaire est mesurée une dernière fois après la fin de la charge et de la décharge.

# FIG. 1

# FIG. 2

# FIG. 3

|  |  | STATE OF CHARGE |  |  |  |  |
|---|---|---|---|---|---|---|
|  |  | 0% | 10% | 20% | .... | 100% |
| TEMPERATURE | −10°C | $\tau_{1-1}$ | $\tau_{1-2}$ | $\tau_{1-3}$ | .... | $\tau_{1-Y}$ |
|  | 0°C | $\tau_{2-1}$ | $\tau_{2-2}$ | $\tau_{2-3}$ | .... | $\tau_{2-Y}$ |
|  | 20°C | $\tau_{3-1}$ | $\tau_{3-2}$ | $\tau_{3-3}$ | .... | $\tau_{3-Y}$ |
|  | .... | .... | .... | .... | .... | .... |
|  | 60°C | $\tau_{X-1}$ | $\tau_{X-2}$ | $\tau_{X-3}$ | .... | $\tau_{X-Y}$ |

# FIG. 4

```
                    ┌──────────┐
                    │  START   │
                    └────┬─────┘
                         ↓
        ┌────────────────────────────────────┐
        │ MEASURE OPEN-CIRCUIT VOLTAGE AT     │~S1
        │ TERMINATION OF CHARGE AND DISCHARGE │
        └────────────────┬───────────────────┘
                         ↓
        ┌────────────────────────────────────┐
        │      SELECT VOLTAGE-CHANGE          │~S2
        │      CONVERGENCE TIME τ             │
        └────────────────┬───────────────────┘
                         ↓
        ┌────────────────────────────────────┐
        │ MEASURE, AT LEAST ONCE, OPEN-CIRCUIT│~S3
        │ VOLTAGE AFTER TERMINATION OF        │
        │ CHARGE AND DISCHARGE                │
        └────────────────┬───────────────────┘
                         ↓
        ┌────────────────────────────────────┐
        │ CALCULATE OPEN-CIRCUIT VOLTAGE AT   │~S4
        │ STABILITY FROM VOLTAGE              │
        │ CHARACTERISTIC EXPRESSION           │
        └────────────────┬───────────────────┘
                         ↓
        ┌────────────────────────────────────┐
        │ ESTIMATE STATE OF CHARGE FROM       │~S5
        │ CALCULATED OPEN-CIRCUIT VOLTAGE     │
        └────────────────┬───────────────────┘
                         ↓
 S7                                          S6
┌──────────┐  No  ╱ VOLTAGE-CHANGE CONVERGENCE ╲
│CALCULATE │◄─────  TIME ELAPSED?               ╲
│RELIABILITY│      ╲                             ╱
└──────────┘        ╲_____╱
                         │ Yes
                         ↓
                    ┌──────────┐
                    │   END    │
                    └──────────┘
```

# FIG. 5

```
          2                            3
          │                            │
┌─────────────────────────┐   ┌──────────────────┐
│ STATE-OF-CHARGE          │   │                  │
│ ESTIMATION DEVICE        │   │                  │
│                          │   │                  │
│   ┌──────────────┐       │   │                  │
│20~│   STORAGE    │       │   │    SECONDARY     │
│   │    UNIT      │       ├───┤    BATTERY       │
│   └──────────────┘       │   │                  │
│                          │   │                  │
│   ┌──────────────┐       │   │                  │
│21~│  COMPUTING   │       │   │                  │
│   │    UNIT      │       │   │                  │
│   └──────────────┘       │   │                  │
└─────────────────────────┘   └──────────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008096328 A
- WO 2009149273 A1
- DE 10305638 A1